# EUROPEAN PATENT APPLICATION

(11) **EP 4 484 760 A1**
(43) Date of publication of application: **01.01.2025**
(21) Application number: 23182761.9
(22) Date of filing: 30.06.2023
(51) Int. Cl.: F04D 29/44, F04D 29/42, F04D 17/16, G06F 1/20, H01L 23/467

(54) **APPARATUS FOR REDUCING AIR TURBULENCE IN A FAN CHASSIS**

(71) Applicant: INTEL Corporation, Santa Clara, CA 95054 (US)
(72) Inventor: SRIVASTAV, Abhishek, 560103 Bangalore (IN); KAPILA, Smit, 560102 Bangalore (IN); TRELLA, Pawel, 80-175 Gdansk (PL); KU, Jeff, Taipei (TW); KURMA RAJU, Prakash, 560068 Bangalore (IN); STANCZAK, Dominik, 80-299 Gdansk, Pomerania (PL)
(74) Representative: 2SPL Patentanwälte PartG mbB

(57) **Abstract**

An apparatus and system for reducing air turbulence in a fan using a flow shaper. The fan including an impeller, a first outlet, and a second outlet. The flow shaper including a partition structure arranged at an inflection area between the first outlet and the second outlet. The flow shaper further including a first fin for the first outlet defining a first channel between the partition structure and the first fin. The first channel extending from a proximity of the impeller to the first outlet.

## Description

### Background

The design of a fan for a personal computer, laptop, or other electronic device has an important impact on the user. Fan noise inside the device may impact the end-user experience and signal an inefficiency in hardware design. This noise may occur, in part, because of the high air turbulence created at the fan outlet or the junction where the air exits the fan chassis and hits the heat exchanger. An air path or flow that is not streamlined may cause noise up to 50 to 60 dB in a single-outlet fan chassis noise and may be even higher in dual-outlet designs. Therefore, an improved method and apparatus for reducing fan chassis turbulence is desired.

### Brief Description of the Figures

Some examples of apparatuses and/or methods will be described in the following by way of example only, and with reference to the accompanying figures, in which
**Fig. 1** shows a schematic of a fan with a flow shaper;
**Fig. 2** shows a schematic of a fan with a heat exchanger, where a flow shaper extends between the fan and the heat exchanger;
**Fig. 3a** shows a visualization of air velocity in a baseline fan chassis;
**Fig. 3b** shows a visualization of air in a fan chassis with a flow shaper;
**Fig. 4a** shows a visualization of noise produced by turbulence in a baseline fan chassis;
**Fig. 4b** shows a visualization of noise produced by turbulence in a fan chassis with a flow shaper;
**Fig. 5** shows a flow shaper integrated into a fan chassis; and
**Fig. 6** shows an external view of a fan with a flow shaper.

### Detailed Description

Some examples are now described in more detail with reference to the enclosed figures. However, other possible examples are not limited to the features of these embodiments described in detail. Other examples may include modifications of the features as well as equivalents and alternatives to the features. Furthermore, the terminology used herein to describe certain examples should not be restrictive of further possible examples.

Throughout the description of the figures same or similar reference numerals refer to same or similar elements and/or features, which may be identical or implemented in a modified form while providing the same or a similar function. The thickness of lines, layers and/or areas in the figures may also be exaggerated for clarification.

When two elements A and B are combined using an "or," this is to be understood as disclosing all possible combinations, i.e., only A, only B as well as A and B, unless expressly defined otherwise in the individual case. As an alternative wording for the same combinations, "at least one of A and B" or "A and/or B" may be used. This applies equivalently to combinations of more than two elements.

If a singular form, such as "a," "an" and "the" is used and the use of only a single element is not defined as mandatory either explicitly or implicitly, further examples may also use several elements to implement the same function. If a function is described below as implemented using multiple elements, further examples may implement the same function using a single element or a single processing entity. It is further understood that the terms "include", "including", "comprise" and/or "comprising", when used, describe the presence of the specified features, integers, steps, operations, processes, elements, components and/or a group thereof, but do not exclude the presence or addition of one or more other features, integers, steps, operations, processes, elements, components and/or a group thereof.

In the following description, specific details are set forth, but examples of the technologies described herein may be practiced without these specific details. Well-known circuits, structures, and techniques have not been shown in detail to avoid obscuring an understanding of this description. "An example/example," "various examples/examples," "some examples/examples," and the like may include features, structures, or characteristics, but not every example necessarily includes the particular features, structures, or characteristics.

Some examples may have some, all, or none of the features described for other examples. "First," "second," "third," and the like describe a common element and indicate different instances of like elements being referred to. Such adjectives do not imply element item so described must be in a given sequence, either temporally or spatially, in ranking, or any other manner. "Connected" may indicate elements are in direct physical or electrical contact with each other and "coupled" may indicate elements co-operate or interact with each other, but they may or may not be in direct physical or electrical contact.

As used herein, the terms "operating", "executing", or "running" as they pertain to software or firmware in relation to a system, device, platform, or resource are used interchangeably and can refer to software or firmware stored in one or more computer-readable storage media accessible by the system, device, platform, or resource, even though the instructions contained in the software or firmware are not actively being executed by the system, device, platform, or resource.

The description may use the phrases "in an example/example," "in examples/examples," "in some examples/examples," and/or "in various examples/examples," each of which may refer to one or more of the same or different examples. Furthermore, the terms "comprising," "including," "having," and the like, as used with respect to examples of the present disclosure, are synonymous.

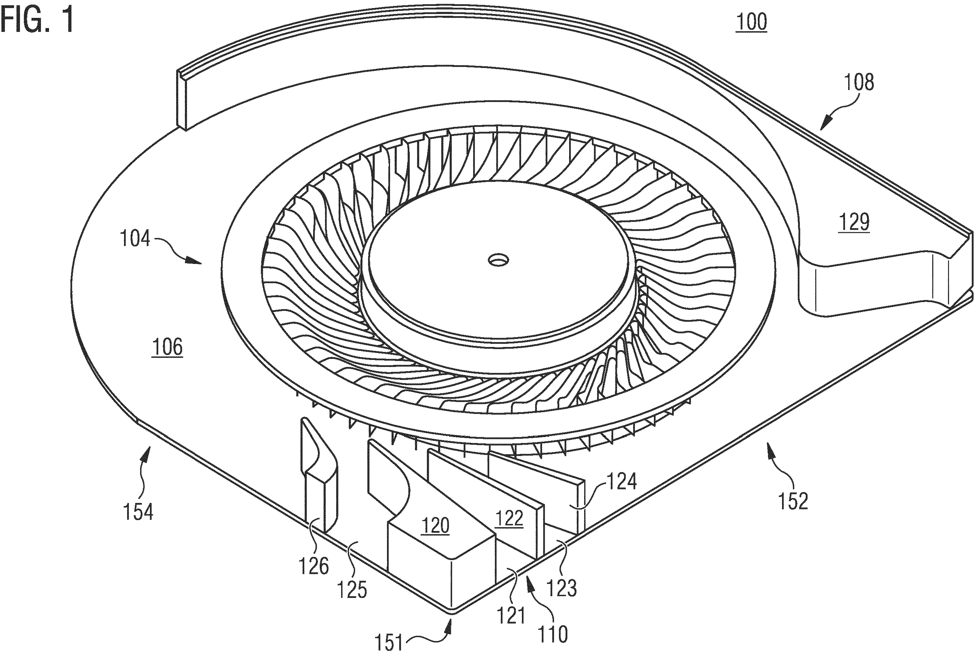

**Fig. 1** shows a schematic image of a flow shaper 110 for a centrifugal fan 100. The centrifugal fan 100 may comprise an impeller 104, a first outlet 152 in a first direction, and a second outlet 154 in a second direction. The flow shaper 110 may comprise a partition structure 120 arranged at an inflection area 151 between the first outlet 152 and the second outlet 154. The flow shaper 110 may further comprise a first fin 122 for the first outlet 152 defining a first channel 121 between the partition structure 120 and the first fin 122. The first channel 121 extends from a proximity of the impeller 104 to the first outlet 152.

A flow shaper 110 may be a device or structure used to control, direct, or manipulate the flow characteristics of a fluid, such as air or liquid, within a specific system or apparatus. The flow shaper 110 may be designed to optimize the fluid flow pattern, reduce turbulence, enhance efficiency, or achieve desired fluid dynamics. A flow shaper 110 that influences the exhaust of a fan, particularly in shaping the airflow to a first or primary outlet, may reduce noise generated due to improper dissipation of air or turbulence. Often turbulence occurs in or near the inflection area of a fan.

An inflection area refers to a specific point, location, or region (e.g. a corner or a curved section) where an outlet transitions from a first direction to a second direction. It can be the meeting point for the first and second outlets or a dividing point that separates one outlet into two oriented in separate directions. The inflection area is an important region that marks the change in flow direction and plays a significant role in directing the fluid or airflow. Moreover, the highest turbulence and resulting noise are often found in the inflection area due to the structures that mark the transition from one outlet to another.

Adding structural additions (e.g. directional fins) to the exit section or outlet of a fan may streamline the airflow as it hits further components, such as a heat exchanger. This streamlining of the flow (e.g. at the exit path from fan chassis 108 to the heat exchanger) may help in reducing the noise due to reduced air turbulence. Additionally, this benefit can be added with negligible additional cost and with minimal changes to the manufacturing process.

Moreover, adding fins to the output of the fan might not increase the height (e.g. z-axis) of the fan chassis 108 nor the overall shape of the fan chassis 108. By streamlining the airflow a better end-user experience can be provided. This is most evident in a reduction of fan noise, which may be reduced by 2 dB or higher.

For example, fins are thin, extended surfaces or structures attached to a fluid handling system or apparatus, designed to influence and control the flow characteristics of a fluid, such as air or liquid. These fins are strategically positioned to optimize fluid dynamics by directing, guiding, or redirecting the flow in desired patterns or paths. They may induce vortices, create turbulence, promote boundary layer control, enhance mixing, or achieve other flow manipulation objectives. Fins may be utilized to improve efficiency, performance, or achieve specific fluid flow requirements in a wide range of applications, including heat exchangers, fans, compressors, and aerodynamic devices.

For example, a partition structure 120 may be a dividing or separating component within a system, apparatus, or device that creates distinct compartments, chambers, or regions. The partition structure 120 may be used to isolate, control, or regulate the flow, pressure, or characteristics of the fluid in different parts of the system. The partition structure 120 may be a physical barrier, wall, or baffle that guides or redirects the fluid, influencing its behavior or interaction with other components. For example, the partition structure 120 may be a cutwater, wedge-shaped, or fin-shaped structure. Generally, the partition structure 120 is the main or predominant structure for dividing a flow between two outlets at an inflection area 151 of a fan.

Fig. 1 further shows that flow shaper 110 may comprise a second fin 124 for the first outlet 152 defining a second channel 123 between the first fin 122 of the first outlet 152 and the second fin 124 of the first outlet 152. A second channel 123 may also extend from a proximity of the impeller 104 to the first outlet 152.

For example, channels are specific pathways or passages through which fluid flows or is directed within a system or apparatus. The first channel 121 may have a defined shape, configuration, or purpose, guiding the fluid in a particular direction or facilitating desired fluid flow characteristics. Adding two or more channels to a flow shaper 110 may enhance fluid distribution and reduce the noise of a fan.

Additional fins (e.g. a second fin 124) are an additional thin, extended surface or structure that is attached to a fluid handling system or apparatus, serving a similar function as the first fin 122. They may be strategically positioned to further influence and control the flow characteristics of a fluid, such as air or liquid, within the system. A second fin 124 works in conjunction with other fins or flow-shaping components to optimize fluid dynamics, enhance heat transfer, promote fluid mixing, or achieve other desired flow manipulation objectives. The second fin 124 and any additional fins may have a specific shape, configuration, or orientation tailored to the particular requirements of the system or application in which it is utilized.

A first outlet 152 may be a specific opening, duct, or passage through which fluid, such as air or liquid, is discharged or expelled from a system, apparatus, or device (e.g. a fan). The first outlet 152 may be designated for a particular purpose, location, or function, and may be associated with specific flow control or directionality features.

Additional outlets (e.g. a second outlet 154) are other distinct openings, ducts, or passages through which fluid is discharged or expelled from a system, apparatus, or device. A second outlet 154 may serve a different purpose, location, or function compared to the first outlet 152. The second outlet 154 and any additional outlets may be designed to direct the fluid flow to a specific area, achieve desired flow distribution, or serve as alternative discharge pathways.

The first channel 121 of a flow shaper 110 may comprise any width. The width of the first channel 121 of a flow shaper 110 may vary between the partition structure 120 and the first fin 122. A minimal width (or average width) of the first channel 121 of a flow shaper 110 between the partition structure 120 and the first fin 122 may be at least 2 millimeters (or at least 4 mm) and/or at most 10 millimeters (or at most 8 mm, or at most 6 mm). This range allows for a balance between providing sufficient space for airflow while maintaining proper air velocity and pressure throughout the fan system. It may help to ensure efficient operation, minimize turbulence, and maximize the fan's performance in terms of airflow delivery and energy efficiency. All channels may comprise any width. Furthermore, the widths of different channels, 121, 123, 125may also be different depending on the design requirements or intentions.

When a heat exchanger is affixed to, is abutting, or otherwise may be adjacent to the first outlet 152 of the centrifugal fan 100, the channel width of the flow shaper 110 may be wider than the width between adjacent fins of a fin stack of a heat exchanger. The wider channel width may allow for smoother fluid flow with reduced resistance. If the channel width is too narrow compared to the fin-stack width, it can lead to increased flow resistance, resulting in higher pressure drop and decreased overall efficiency of the heat exchanger.

Fig. 1 further shows that the flow shaper 110 may further comprise a first fin 126 for the second outlet 154 defining a first channel 125 of the second outlet 154 between the partition structure 120 and the first fin 126 for the second outlet 154. The first channel 125 of the second outlet 154 extends to the second outlet 154. Having a channel to a second outlet 154, in addition to the first, provides flexibility in fluid distribution, enables improved system balancing, and allows for more precise control of flow rates and directions within the centrifugal fan 100. The first channel 125 of the second outlet 154 may extend from a proximity of the impeller 104 to the second outlet.

A centrifugal fan 100 may be any type of fan or blower that operates on the principle of centrifugal force. It consists of an impeller 104 or rotor that rotates within a housing or casing 108, creating a radial flow of the fluid. The centrifugal fan 100 may be used to generate fluid movement, create pressure differentials, and facilitate the transfer of heat or mass in various applications. Although the figures show a centrifugal fan 100, other types of fans may be used, such as axial fans, crossflow fans, and vaneaxial fans, among others.

In certain high-performance laptops, gaming laptops, or other electronic devices that generate a significant amount of heat, manufacturers may opt for centrifugal fans 100 instead of or in conjunction with axial fans. Centrifugal fans 100, also known as radial fans, operate by pulling air into the fan housing at the center and then redirecting it perpendicular to the axis of rotation before expelling it. This design allows for higher static pressure and improved airflow in constrained spaces, making them suitable for laptops with more demanding cooling requirements.

The fan (e.g. centrifugal fan) comprises an impeller. An impeller 104 may be a rotating component within a fluid handling system, typically used in pumps, fans, or turbines. An impeller 104 may comprise blades or vanes that impart kinetic energy to the air or fluid, resulting in its movement, pressure change, or flow acceleration. It may be designed to efficiently transfer energy from the mechanical system to the fluid, enabling pumping, mixing, or propulsion. Although the figures show an impeller, other types of forced air fan assemblies may be used, such as propellers and bladeless fans.

The proximity of an impeller 104 refers to the close distance between the impeller 104 and other components within a fluid handling system. It signifies the spatial relationship and nearness of the impeller 104 to surrounding elements, such as the fins, the partition structure, housing, blades, channels, or any other structures involved in the fluid flow process.

Extending channels from a close proximity of the impeller 104 allows for a more direct and efficient transfer of fluid or air, minimizing energy losses and improving overall system performance. This may help to optimize flow dynamics, reduce turbulence, and enhance the effectiveness of the impeller 104 in generating and directing fluid flow. Channels may be extended from a proximity as close as possible to the impeller 104 when manufacturing and other tolerances are considered. Proper space should be left between the impeller 104 and the channels to avoid damaging the fan or reducing airflow.

For example, the first fin 122 for the first outlet (and/or the second fin for the first outlet and/or the first fin for the second outlet) may be spaced apart from the impeller by at least 1 millimeter (or at least 0.01 mm, at least 0.1 mm, at least 0.5 mm, or at least 2 mm) and/or at most 2 millimeters (or at most 1 mm or at most 3 mm). In this way, the first channel of the first outlet (and/or the second channel of the first outlet and/or the first channel of the second outlet) may start in proximity to the impeller. Keeping the distance between the first fin 122 and the impeller 104 within the mentioned range may ensure a controlled and efficient flow path, minimizing flow disturbances, optimizing energy transfer, and maximizing the fan's performance by effectively harnessing the impeller's rotational energy.

The first fin 122 for the first outlet 152 may comprise or may be made of plastic and/or metal (e.g. aluminum and/or copper). The use of aluminum, copper, or similar materials for fins in heat exchangers provides excellent thermal conductivity, enabling efficient heat transfer and improved overall performance of the heat exchanger.

A height of the first fin 122 for the first outlet 152 may be at least 3.5 millimeters (or at least 10 mm, at least 7 mm, at least 2 mm, or at least 1 mm) and/or at most 15 millimeters (or at most 7 mm, at most 10 mm, at most 18 mm, or at most 20 mm). By keeping the height of the first, second, or additional fins in a fan within the mentioned range, a compact profile in the vertical plane (e.g. z-axis) may be achieved, allowing for efficient use of space in the fan's design while still providing sufficient surface area for effective heat transfer and maintaining a streamlined airflow path.

The length of the first fin 122 for the first outlet 152 may be at least 3.5 millimeters (or at least 10 mm, at least 7 mm, at least 2 mm, or at least 1 mm) and/or at most 15 millimeters. Maintaining the length of the first, second, or additional fins in a fan within the range of 3.5 millimeters to 15 millimeters (or at most 7 mm, at most 10 mm, at most 18 mm, or at most 20 mm) may allow for a compact design along the horizontal plane (e.g. x and/or y axes), enabling efficient utilization of space while providing adequate surface area for effective heat dissipation and ensuring an optimized airflow path.

The first channel 121 may extend at least partially along a tangent of the impeller 104. Extending along a tangential path of an impeller 104 may provide several benefits, including improved fluid flow direction, enhanced energy transfer, increased efficiency, and reduced turbulence. Only partially extending along the path allows a controlled redirection of the fluid or airflow. By initially aligning the path tangentially with the impeller 104's rotational motion, the flow can harness the initial momentum and direction provided by the impeller 104. The subsequent change in path allows for desired adjustments in flow direction, velocity, or distribution, enabling more precise control and optimization of the fluid dynamics within the system. This approach provides flexibility in directing the flow to specific areas or components, optimizing performance, and achieving desired flow patterns or characteristics.

The first channel 121 may extend at least partially along a path originating from a permitter of the impeller 104. Originating a channel at a perimeter of the impeller 104 may allow for better utilization of available space within the fan. It may enable the channel or flow path to navigate around other components or structures, maximizing the use of the available area and ensuring efficient integration of the flow path within the overall design. Moreover, by deviating from a tangential direction, it offers the opportunity to redirect the flow precisely to target specific areas, components, or desired flow patterns within the system. This flexibility can be beneficial for optimizing heat transfer, achieving desired flow rates, or managing fluid distribution as per the system requirements. Additionally, a path originating at the perimeter can help minimize flow interference with other components or structures.

A path along which a channel extends may be a tangential path. A tangential path may enable a more direct and focused transfer of fluid or air, maximizing the utilization of the impeller's rotational motion and optimizing the overall performance of the system. Furthermore, a tangential path may allow for a more straightforward and streamlined design, which can simplify the manufacturing process, reduce production costs, and enhance overall production efficiency. The channel's alignment with the impeller's rotational motion facilitates a more intuitive and efficient construction of the flow shaper 110 component.

In the context of motion or flow, a direction refers to the path or course in which something moves or progresses. It indicates the orientation or trajectory of movement. A first direction and a second direction denote distinct paths or orientations of airflow. The contrast between separate directions (e.g. a first direction and a second direction) lies in their distinct angles, pathways, routes, or destinations. They may vary in terms of angle, orientation, velocity, or intended outcome, resulting in different effects or outcomes based on the chosen direction. The selection of a specific direction can have significant implications on the overall motion, flow, or desired result in a given context. For example, a first direction may refer to the trajectory of air toward a heat exchanger or an exhaust of an electronic device (e.g. a laptop), whereas a second direction may refer to the trajectory of air towards internal components of the electronic device. Similarly, both directions may refer to separate heat exchangers or other components (e.g. CPU, motherboard, graphics card, etc.) within the electronic device. For example, the latter scenario may occur in a hyperbaric cooling system where air may be first cooled before entering the fan and the cool air may then be distributed to components within the electronic device.

The first direction of the first outlet may extend along an edge of the first outlet (e.g. an edge of a chassis of the fan) or may be a main airflow direction of air output through the first outlet. Correspondingly, the second direction of the second outlet may extend along an edge of the second outlet (e.g. an edge of a chassis of the fan) or may be a main airflow direction of air output through the second outlet. The main airflow direction may target a direction of the outlet or be averaged over the airflow through the outlet.

The first direction of the first outlet and the second direction of the second outlet may enclose an angle larger than 60° (or larger than 80°) and/or smaller than 120° (or smaller than 100°). For example, a first direction and a second direction may be largely perpendicular (e.g. 90°). Enclosing a mentioned angle between the first and second directions of the fan outlets may ensure efficient air distribution, allowing for effective airflow in different directions. The angle range facilitates system balancing, preventing uneven flow distribution and maintaining pressure equilibrium. Additionally, it provides better airflow control, allowing for precise adjustment of flow rates and directions. Lastly, the angle range may reduce flow interference and turbulence, promoting smooth and stable airflow within the system.

The partition structure 120 may be a cutwater or a secondary cutwater. A cutwater may refer to a design feature often found in fluid flow applications, such as pumps, fans, or turbines. It may be a shape or structure typically designed to reduce or minimize resistance caused by fluid flow. The cutwater may be designed to guide the fluid smoothly around the object and prevent excessive turbulence or drag.

In addition to the partition structure 120, Fig. 1 shows another cutwater 129 located at the opposite end of the first outlet 152. This cutwater, sometimes known as a primary or compression cutwater may be used for air compression. A cutwater 129 for compression in a centrifugal fan 100 may serve to create a barrier or obstruction that redirects the airflow. It may help to increase the pressure of the air as it passes through the fan, promoting efficient compression. This design feature may enhance the fan's ability to generate higher pressures and deliver a more concentrated airflow, making it suitable for applications that require robust air compression and movement.

For example, a fan chassis 108 may comprise the flow shaper 110. A fan chassis 108 is the structural enclosure or housing that houses the fan components, such as the motor, impeller 104, backplate or baseplate 106, and other associated parts, providing support, protection, and structural integrity to the fan system. The design of the fan chassis 108 can include specific structures or features that shape the outlets of the fan. This can involve the presence of openings or ducts in the chassis that guide the airflow in desired directions or provide designated outlets for the expelled air. The fan chassis 108 may play a role in directing and controlling the airflow path, which can be influenced by its design and configuration. Integrating a flow shaper 110 into a fan chassis 108 installation may eliminate the need for additional components, and provides a more compact and durable design.

The height of the fan chassis 108 may be at least 3.5 millimeters (or at least 10 mm, at least 7 mm, at least 2 mm, or at least 1 mm) and/or at most 15 millimeters (or at most 7 mm, at most 10 mm, at most 18 mm, or at most 20 mm). Having a fan chassis 108 with a thickness within the mentioned range may ensure the structural integrity of the fan assembly by providing a sufficient thickness to securely support and protect the internal components, such as the motor and impeller 104. The specified thickness may also contribute to the rigidity and stability of the fan chassis 108, reducing vibrations and flexing that can negatively impact performance and increase noise levels. Additionally, keeping the fan chassis 108 within this thickness range may allow for optimal space utilization, making it suitable for applications with limited space or where a compact design is desired.

For example, the height of the first fin 122 for the first outlet 152 of a fan chassis 108 may extend the height of the outlet. Extending the fin fix to the full height of the outlet may help to minimize air leakage or bypass, ensuring that the maximum amount of air is directed toward the desired outlet. This may result in enhanced efficiency and effectiveness of the fan's airflow, optimizing its performance and achieving better airflow management within the system.

The first fin 122 for the first outlet 152 may be integrally formed on the top or base of the fan chassis 108. Integrating the fin into a top or base (e.g. a baseplate 106) of the fan may allow for easier assembly of the fan as well as ensure the flow shaper 110 is in the correct position. A baseplate 106 may be a component of the fan chassis 108 that provides structural support and stability to the fan assembly. It is usually located at the rear of the fan and serves as a mounting surface for the fan motor and other internal components. The baseplate 106 may help secure the components in place and adds rigidity to the fan chassis 108.

More details and optional aspects may be described in connection with examples described below.

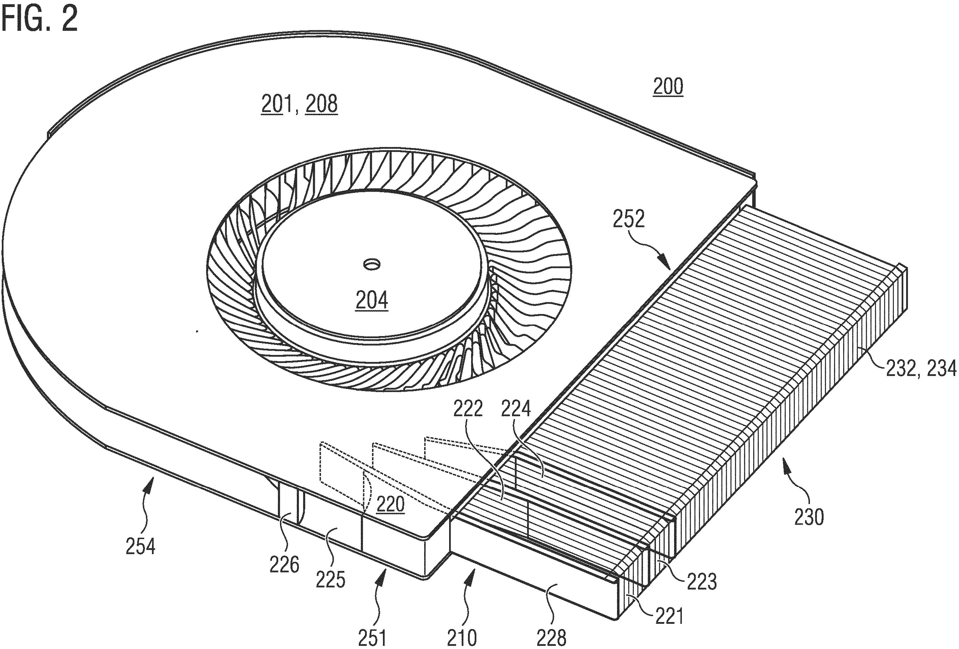

**Fig.** 2 shows that a first fin 222 of a flow shaper 210 may extend beyond the first outlet 252 of the centrifugal fan. Extending the first, second, or additional fins beyond the outlet of the fan provides additional benefits. Firstly, it may help to reduce air recirculation and backflow by directing the airflow away from the outlet 252. This ensures that the expelled air is not immediately drawn back into the fan 201, improving overall efficiency, and preventing performance degradation. Secondly, extending the fins can contribute to better noise reduction by reducing turbulence and air disturbances near the outlet. This may lead to smoother and quieter airflow, enhancing user comfort and reducing noise pollution. Additionally, the extended fins can serve as a protective barrier, preventing foreign objects or debris from entering the fan assembly and potentially causing damage. Overall, extending the fins beyond the outlet of the fan improves airflow directionality, enhances efficiency, reduces noise, and provides added protection to the fan system.

Fig. 2 shows a heat exchanger 230 affixable to a centrifugal fan 201. The heat exchanger 230 may comprise a plurality of heat-transfer fins 232 arranged in a fin stack 234, wherein the fin stack 234 has an inlet. The heat exchanger 230 may further comprise a plurality of channels 221 defined by a plurality of flow-shaping fins extending beyond the inlet of the fin stack 234, wherein a width of the channels may be greater than the width between adjacent heat-transfer of the fin stack 234.

A heat exchanger 230 may be a device or apparatus designed to transfer thermal energy between two or more fluids or substances at different temperatures. It facilitates the efficient exchange of heat by enabling the transfer of thermal energy from a fluid or substance with a higher temperature to one with a lower temperature. Heat exchangers are commonly used in various applications for heating, cooling, and energy recovery purposes. In electronic devices they may be used to dissipate heat generated by components such as processors, transistors, or power modules, ensuring optimal operating temperatures and preventing overheating that may potentially damage sensitive electronic circuits.

The heat exchanger 230 typically consists of a series of tubes, plates, or other heat transfer surfaces that are physically separated by spaces through which air flows. This arrangement facilitates the transfer of heat from the hot air to the cold tubes, plates, or other heat transfer surfaces through conduction, convection, or radiation. The heat exchanger 230 may also incorporate fins, baffles, or other flow-shaping components to enhance heat transfer efficiency. The primary objective of a heat exchanger 230 is to maximize the heat transfer rate while minimizing energy losses and pressure drop.

Integrating a flow shaper into a heat exchanger 230 instead of a fan 201 offers several benefits. Firstly, it allows for improved heat transfer efficiency within the heat exchanger 230. The flow shaper can help distribute the air evenly across the heat exchange surfaces, ensuring maximum contact and promoting effective heat exchange. This leads to enhanced thermal performance and improved overall heat transfer rates.

Secondly, incorporating a flow shaper into the heat exchanger 230 can help minimize pressure drop or resistance within the system. By guiding and controlling the fluid or airflow, the flow shaper reduces turbulence and unnecessary flow disruptions, resulting in smoother fluid movement. This translates to lower energy consumption and improved system efficiency.

Additionally, the presence of a flow shaper in the heat exchanger 230 can contribute to noise reduction. By optimizing the fluid flow patterns and minimizing turbulent flow, the flow shaper may help to reduce noise generated by the fluid movement within the heat exchanger 230, enhancing user comfort.

A flow-shaping fin 122 may be a thin, extended surface or structure attached to a heat exchanger 230, cooling device, or similar apparatus to enhance heat transfer between the fluid and the surrounding environment. The first fin 222 increases the surface area available for heat exchange, facilitating efficient heat dissipation or absorption.

Flow-shaping fins 222, 224, 228 may be integrally formed into the heat-transfer fins of the fin stack 234. By integrating the flow-shaping fins into the heat exchanger 230, airflow may be more accurately directed into the heat exchanger 230, thus minimizing turbulence, reducing noise, and increasing the efficiency of both the fan 201 and heat exchanger 230. Additionally, an assembly may be simplified when the heat exchanger 230 is connected to a fan 201.

A partition or cutwater fin 228 may be a flow-shaping fin that may abut a partition or a cutwater 220 of a centrifugal fan 201. This may improve or increase the impact the cutwater has on reducing noise and turbulence originating in the fan chassis. Additionally, this may help form a first channel 221 between the first flow-shaping fin 222 of the heat exchanger 230 and the partition fin 228 by extending the effects of the partition 220 into the heat exchanger 230.

A width of a channel between flow-shaping fins may comprise any width. The width of the first channel 221 of a flow shaper 210 may vary between the partition fin 228 or structure 220 and the first fin 222. A minimal width (or average width) of the first channel 221 of a flow shaper 210 between the partition fin 228 or structure 220 and the first fin 222 may be at least 2 millimeters (or at least 4 mm) and/or at most 10 millimeters (or at most 8 mm or at most 6 mm). The width should be adapted to the heat exchanger 230, fan 201, and the specific thermal requirements to provide versatility and optimization for the fin design. A channel width of two to six millimeters may allow for efficient and controlled airflow within the heat exchanger 230, ensuring effective heat transfer across the exchange surfaces. The specified channel width may also facilitate the desired flow rates while minimizing pressure drop and flow disruptions. Furthermore, the widths of different channels, 221, 223, 225 may also be different depending on the design requirements or intentions.

A flow-shaping fin 222, 224, 228 may comprise of at least one of plastic or a metal (e.g. aluminum or copper). Flow-shaping fins 222, 224, 228 in heat exchangers may be made of metals such as aluminum, copper, or other highly conductive materials due to their excellent thermal conductivity. This allows for efficient heat transfer between the fluid and the fins, enhancing overall heat exchanger 230 performance. Additionally, metals provide durability and structural integrity to withstand the demanding operating conditions of heat exchangers, ensuring long-term reliability. Plastic may also be used due to its ease of manufacture, availability, and readiness to be shaped. The choice of these materials also facilitates manufacturing processes, enabling the fins to be easily formed and integrated into the heat exchanger 230 design.

The height of the heat exchanger 230 may be at least 3.5 millimeters (or at least 10 mm, at least 7 mm, at least 2 mm, or at least 1 mm) and/or at most 15 millimeters (or at most 7 mm, at most 10 mm, at most 18 mm, or at most 20 mm). may be at least 3.5 millimeters and/or at most 15 millimeters.

A minimum height should ensure sufficient surface area for effective heat transfer, maximizing thermal efficiency. A maximum height may be chosen to maintain a compact profile, allowing for space-efficient integration in various systems while minimizing overall size and weight. A height of a heat exchanger 230 may be tailored to specific applications while balancing thermal performance and space constraints.

The length of the flow-shaping fin may be at least 0.1 millimeters (or at least 1 mm, at least 0.05 mm, at least 0.01 mm) and/or at most 5 millimeters (or at most 1 mm, at most 3 mm, at most 10 mm). A length of a flow-shaping fin may be chosen to allow for the most efficient direction of airflow into the heat exchanger. It may also be chosen to maintain a compact profile, allowing for the most compatible integration in various fans, or for a space-efficient design minimizing overall size and weight.

Channels may extend at least partially along a path originating from a permitter of an impeller of the centrifugal fan. Originating a channel at a perimeter of the impeller may allow for better utilization of available space within the fan. It may enable the channel or flow path to navigate around other components or structures, maximizing the use of the available area and ensuring efficient integration of the flow path within the overall design. Moreover, by deviating from a tangential direction, it offers the opportunity to redirect the flow precisely to target specific areas, components, or desired flow patterns within the system. This flexibility can be beneficial for optimizing heat transfer, achieving desired flow rates, or managing fluid distribution as per the system requirements. Additionally, a path originating at the perimeter can help minimize flow interference with other components or structures.

Fig. 2 further shows a system 200 comprising a centrifugal fan 201 and a heat exchanger 230. The centrifugal fan 201 comprises an impeller 204 and a first outlet 252 in a first direction and a second outlet 254 extending in a second direction. The heat exchanger 230 abuts the first outlet 252 of the centrifugal fan. The system 200 further comprises a partition structure 220 arranged at an inflection area 251 between the first outlet and the second outlet 254, and a first fin 222 for the first outlet defining a first channel 221 between the partition structure 220 and the first fin 222. The first channel 221 extends from a proximity of the impeller 204 to the first outlet.

Adding fins to the system allows for streamlining of the flow at the exit path from fan chassis 208 to a heat exchanger 230. This may help in reducing the noise due to reduced air turbulence. Additionally, this approach improves the thermals of the system by more efficiently directing airflow through the heat exchanger 230. If the fins of the system are integrated into the heat exchanger 230, in full or in part, an increase in the surface areas of the heat exchanger 230 can reduce the heat of the system without an impact on airflow.

Fig. 2 further shows a system comprising a second fin 224 for the first outlet defining a second channel 223 between the first fin 122 of the first outlet and the second fin 124 of the first outlet, wherein the second channel 223 extends from a proximity of the impeller to the first outlet. Adding multiple fins and channels to the system can further improve airflow and reduce noise reduce heat by reducing further areas of turbulence and moving air more quickly through the heat exchanger 230. Additional fins may result in additional noise reduction as well as better thermal efficiency.

Fig. 2 further shows a system where the first fin 222 extends beyond the first outlet into the heat exchanger 230. Extending fins through the heat exchanger 230 may allow for better integration with the heat exchanger 230 and a better direction of airflow. As well as by increasing the thermal efficiency by increasing the surface area of the heat exchanger 230.

The first, second, or further channel 221, 223, 225 may comprise a width, wherein the width of at least two millimeters, at most six millimeters, and/or greater than a width between adjacent fins of a fin stack 234 of the heat exchanger 230.

Fig. 2 further shows a first fin 226 for the second outlet 254 defining a first channel 225 of the second outlet 254 between the partition structure 220 and the first fin 226 for the second outlet 254, wherein the first channel 225 of the second outlet 254 extends to the second outlet 254. Having a channel to a second outlet 254, in addition to the first, provides flexibility in fluid distribution, enables improved system balancing, and allows for more precise control of flow rates and directions within the centrifugal fan.

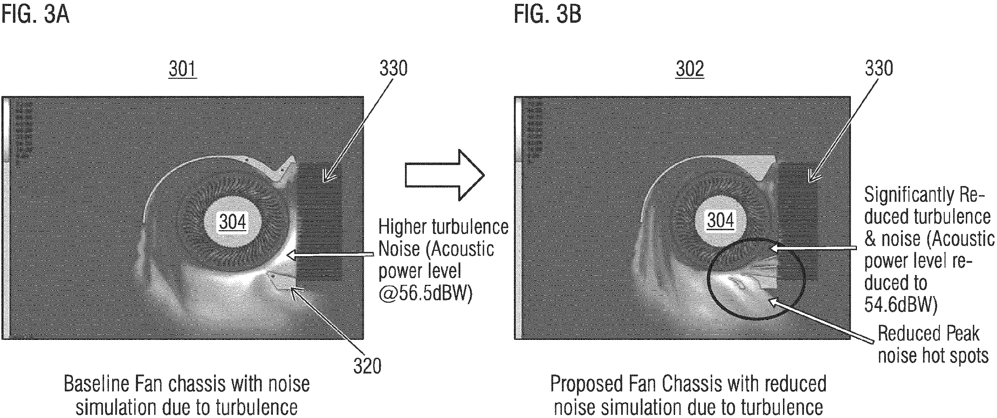

More details and optional aspects of the device of Fig. 2 may be described in connection with examples described above (e.g. Fig. 1) or below (e.g. Fig. 3A to Fig. 6).

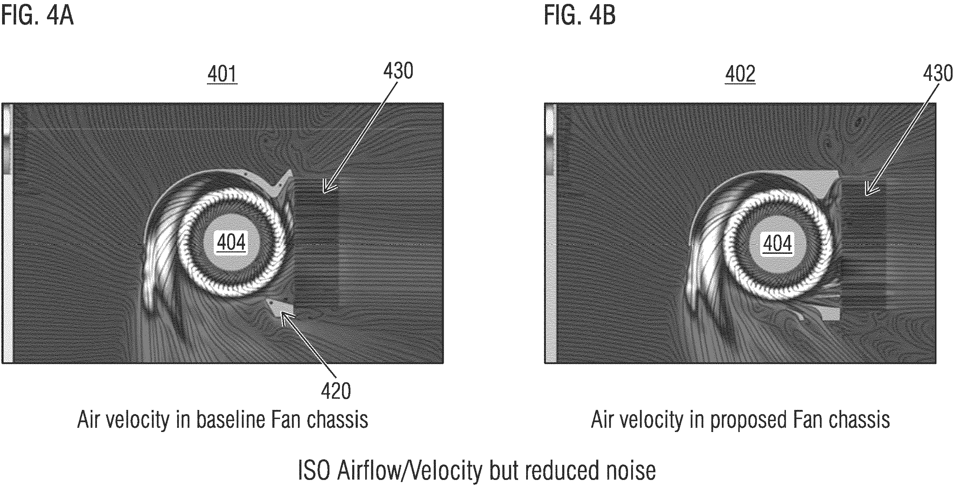

**Figs. 3A** and **3B** show turbulence and noise in a baseline fan chassis 301 and a fan chassis with a flow shaper 302, respectively. **Figs. 4A** and **4B** show air velocity in a baseline fan chassis 401 and a fan chassis with a flow shaper 402, respectively. Fan chassis plays an important role in shaping the airflow to the heat exchanger 330, 430. Based on simulation data on several fan chassis models it is observed that most of the noise generated is due to improper dissipation of air from the fan outlet towards heat exchanger 330, 430. This is shown in Figs. 3A and 3B. In both figures noise power and airflow/air velocity simulation were done on a fan chassis with and without a flow shaper.

Simulations for a fan chassis with and without a flow shaper used the same heat exchanger 330, 430 and a fixed fan speed at 4200 rpm. In both chassis, noise is generated from the blade pass of an impeller 304, 404 as well as from cutwater region 320, 420. While the noise generated from blades is minimal, the noise generated from the cutwater region is more prominent.

In the baseline chassis of Fig. 3A, turbulence and noise were measured at an exit bath between the impeller and the heat exchanger 230 at 56.6 decibel watts (dBW). In the chassis with the flow shaper of Fig. 3B, significantly reduced turbulence and noise were measured at 54.6 dBW. Thus, the expected noise reduction was determined to be 1.9 dB. Further measurement found that the noise reduction occurred around 2500-3000 hertz (Hz), which is a perceivable acoustic reduction.

Additionally, airflow was measured with and without the proposed modification. Fig. 4A shows air velocity in a baseline fan chassis 108 and Fig. 4B shows air velocity in a fan chassis 108 with a flow shaper. No negative effect of modification was observed. Rather, a slight improvement in average air speed across three points was observed in the fan chassis 108 with the flow shaper. The summary of measurement is highlighted below in Table 1.

**Table 1**

| | **Without Flow Shaper** | **With Flow Shaper** | |
|---|---|---|---|
| PSU Voltage | 9.30 | 9.30 | V |
| Fan Voltage | 9.20 | 9.20 | V |
| Air Speed - point A(Left) | 2.00 | 2.00 | m/s |
| Air Speed - point | | | |
| B(Centre) | 2.80 | 3.40 | m/s |
| Air Speed - point C(Right) | 3.80 | 3.30 | m/s |
| Average Air Speed | **2.87** | **2.90** | m/s |
| Cross-Section Area | 4.55 | 4.55 | cm^2 |
| Airflow Rate | **1.30E-03** | **1.32E-03** | m^3/s |

Therefore, adding directional fins in the fan chassis exit section streamlined the airflow as it hit the heat exchanger 330, 430. This streamlining of the flow (at the exit path from the fan chassis to the heat exchanger 330, 430) may help in reducing the noise due to reduced air turbulence.

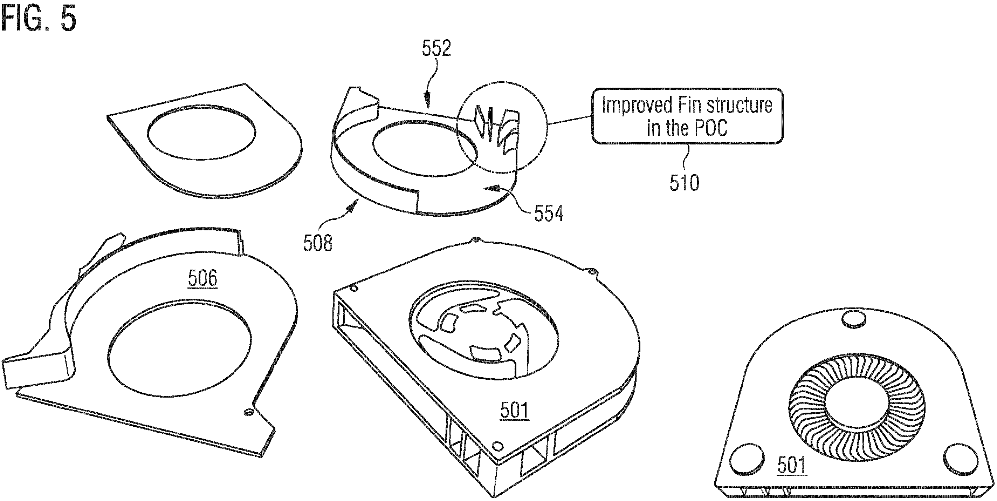

Adding a flow shaper to a fan may be done simply by integrating it into the fan's housing or chassis. **Fig. 5** shows a flow shaper 510 integrated into a fan chassis 508 at an inflection area between the first 552 and the second exhaust 554 or outlet of the fan 501. This flow shaper may also be integrated into a baseplate 506 of a fan.

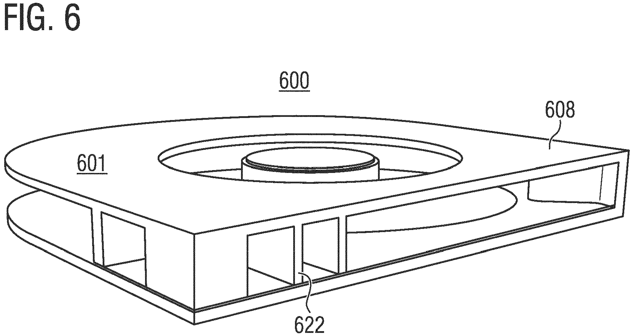

Adding directional fins 622 to a fan chassis 608 does not add significant cost and has no Z impact on the fan or system chassis 608. This can be seen in **Fig. 6****,** which shows a profile of a fan 601 comprising a flow shaper. The addition of the fins 622 to the chassis 608 adds no additional height to the fan.

The aspects and features described in relation to a particular one of the previous examples may also be combined with one or more of the further examples to replace an identical or similar feature of that further example or to additionally introduce the features into the further example.

It is further understood that the disclosure of several steps, processes, operations, or functions disclosed in the description or claims shall not be construed to imply that these operations are necessarily dependent on the order described, unless explicitly stated in the individual case or necessary for technical reasons. Therefore, the previous description does not limit the execution of several steps or functions to a certain order. Furthermore, in further examples, a single step, function, process, or operation may include and/or be broken up into several sub-steps, -functions, -processes, or -operations.

If some aspects have been described in relation to a device or system, these aspects should also be understood as a description of the corresponding method. For example, a block, device, or functional aspect of the device or system may correspond to a feature, such as a method step, of the corresponding method. Accordingly, aspects described in relation to a method shall also be understood as a description of a corresponding block, a corresponding element, a property, or a functional feature of a corresponding device or a corresponding system.

An example (e.g. example 1) is a flow shaper for a centrifugal fan, wherein the centrifugal fan comprises an impeller, a first outlet in a first direction, and a second outlet in a second direction. The flow shaper comprises a partition structure arranged at an inflection area between the first outlet and the second outlet, and a first fin for the first outlet defining a first channel between the partition structure and the first fin, wherein the first channel extends from a proximity of the impeller to the first outlet.

Another example (e.g. example 2) relates to a previously described example (e.g. example 1), further comprising a second fin for the first outlet defining a second channel between the first fin of the first outlet and the second fin of the first outlet, wherein the second channel extends from a proximity of the impeller to the first outlet.

Another example (e.g. example 3) relates to a previously described example (e.g. one of the examples 1 - 2), wherein the first fin extends beyond the first outlet of the centrifugal fan.

Another example (e.g. example 4) relates to a previously described example (e.g. one of the examples 1 - 3), wherein the first channel comprises a width and the width is at least one of at least two millimeters, at most six millimeters, or greater than a width between adjacent fins of a fin stack of a heat exchanger abutting the first outlet of the centrifugal fan.

Another example (e.g. example 5) relates to a previously described example (e.g. one of the examples 1 - 4), further comprising a first fin for the second outlet defining a first channel of the second outlet between the partition structure and the first fin for the second outlet, wherein the first channel of the second outlet extends to the second outlet.

Another example (e.g. example 6) relates to a previously described example (e.g. one of the examples 1 - 5), wherein the first channel of the second outlet extends from a proximity of the impeller.

Another example (e.g. example 7) relates to a previously described example (e.g. one of the examples 1 -6), wherein the first fin for the first outlet comprises at least one of aluminum or copper.

Another example (e.g. example 8) relates to a previously described example (e.g. one of the examples 1 - 7), wherein a height of the first fin for the first outlet is at least 3.5 millimeters and at most 15 millimeters.

Another example (e.g. example 9) relates to a previously described example (e.g. one of the examples 1 - 8), wherein a length of the first fin for the first outlet is at least 3.5 millimeters and at most 15 millimeters.

Another example (e.g. example 10) relates to a previously described example (e.g. one of the examples 1 - 9), wherein a distance of the first fin from the impeller is at least 0.01 millimeters and at most 1 millimeter.

Another example (e.g. example 11) relates to a previously described example (e.g. one of the examples 1 - 10), wherein the first channel of the first outlet extends at least partially along a tangent of the impeller.

Another example (e.g. example 12) relates to a previously described example (e.g. one of the examples 1 - 11), wherein the first channel of the first outlet extends at least partially along a path originating from a permitter of the impeller.

Another example (e.g. example 13) relates to a previously described example (e.g. example 12), wherein the path is a tangential path.

Another example (e.g. example 14) relates to a previously described example (e.g. one of the examples 1 - 13), wherein the first direction and the second direction enclose an angle larger than 60° and smaller than 100°.

Another example (e.g. example 15) relates to a previously described example (e.g. one of the examples 1 - 14), wherein the partition structure is a cutwater.

An example (e.g. example 16) is a fan chassis for a centrifugal fan comprising the flow shaper according to a previously described example (e.g. one of the examples 1 - 15).

Another example (e.g. example 17) relates to a previously described example (e.g. example 16), wherein a height of the fan chassis is at least 3.5 millimeters and at most 15 millimeters.

Another example (e.g. example 18) relates to a previously described example (e.g. one of the examples 16 - 17), wherein a height of the first fin for the first outlet extends a height of the first outlet.

Another example (e.g. example 19) relates to a previously described example (e.g. one of the examples 16 - 18), wherein the first fin for the first outlet integrally formed on a top or base of the fan chassis.

An example (e.g. example 20) relates to a heat exchanger affixable to a centrifugal fan. The heat exchanger comprising a plurality of heat-transfer fins arranged in a fin stack, wherein the fin stack has an inlet. The heat exchanger further comprising a plurality of channels defined by a plurality of flow-shaping fins extending beyond the inlet of the fin stack, wherein a width of the channels is greater than a width between adjacent heat-transfer fins of the fin stack.

Another example (e.g. example 21) relates to a previously described example (e.g. example 20), wherein the flow-shaping fins are integrally formed into the heat-transfer fins of the fin stack.

Another example (e.g. example 22) relates to a previously described example (e.g. one of the examples 20 - 21), wherein the width of the plurality of channels is at least two millimeters and at most six millimeters.

Another example (e.g. example 23) relates to a previously described example (e.g. one of the examples 20 - 22), wherein the flow-shaping fins comprise at least one of aluminum or copper.

Another example (e.g. example 24) relates to a previously described example (e.g. one of the examples 20 - 23), wherein a height of the heat exchanger is at least 3.5 millimeters and at most 15 millimeters.

Another example (e.g. example 25) relates to a previously described example (e.g. one of the examples 20 - 24), wherein a length of the flow-shaping fins is at least 0.1 millimeters and at most 5 millimeters.

Another example (e.g. example 26) relates to a previously described example (e.g. one of the examples 20 - 25), wherein the plurality of channels extend at least partially along a path originating from a permitter of an impeller of the centrifugal fan.

An example (e.g. example 27) relates to a system comprising a centrifugal fan and a heat exchanger. The centrifugal fan comprises an impeller and a first outlet in a first direction and a second outlet in a second direction. The heat exchanger abuts the first outlet of the centrifugal fan. The system further comprises a partition structure arranged at an inflection area between the first outlet and the second outlet and a first fin for the first outlet defining a first channel between the partition structure and the first fin, wherein the first channel extends from a proximity of the impeller to the first outlet.

Another example (e.g. example 28) relates to a previously described example (e.g. example 27), further comprising a second fin for the first outlet defining a second channel between the first fin of the first outlet and the second fin of the first outlet, wherein the second channel extends from a proximity of the impeller to the first outlet.

Another example (e.g. example 29) relates to a previously described example (e.g. one of the examples 27 - 28), wherein the first fin extends beyond the first outlet into the heat exchanger.

Another example (e.g. example 30) relates to a previously described example (e.g. one of the examples 27 - 29), wherein the first channel comprises a width and the width is at least one of at least two millimeters, at most six millimeters, or greater than a width between adjacent heat-transfer fins of a fin stack of the heat exchanger.

Another example (e.g. example 31) relates to a previously described example (e.g. one of the examples 27 - 30), further comprising a first fin for the second outlet defining a first channel of the second outlet between the partition structure and the first fin for the second outlet, wherein the first channel of the second outlet extends to the second outlet.

The disclosed methods, apparatuses, and systems are not to be construed as limiting in any way. Instead, the present disclosure is directed toward all novel and nonobvious features and aspects of the various disclosed examples, alone and in various combinations and subcombinations with one another. The disclosed methods, apparatuses, and systems are not limited to any specific aspect or feature or combination thereof, nor do the disclosed examples require that any one or more specific advantages be present, or problems be solved.

Theories of operation, scientific principles, or other theoretical descriptions presented herein in reference to the apparatuses or methods of this disclosure have been provided for the purposes of better understanding and are not intended to be limiting in scope. The apparatuses and methods in the appended claims are not limited to those apparatuses and methods that function in the manner described by such theories of operation.

The following claims are hereby incorporated in the detailed description, wherein each claim may stand on its own as a separate example. It should also be noted that although in the claims a dependent claim refers to a particular combination with one or more other claims, other examples may also include a combination of the dependent claim with the subject matter of any other dependent or independent claim. Such combinations are hereby explicitly proposed, unless it is stated in the individual case that a particular combination is not intended. Furthermore, features of a claim should also be included for any other independent claim, even if that claim is not directly defined as dependent on that other independent claim.

## Claims

1. A flow shaper (110) for a centrifugal fan (100), wherein the centrifugal fan (100) comprises an impeller (104), a first outlet (152) in a first direction, and a second outlet (154) in a second direction, the flow shaper (110) comprising:
a partition structure (120) arranged at an inflection area (151) between the first outlet (152) and the second outlet (154); and
a first fin (122) for the first outlet (152) defining a first channel (121) between the partition structure (120) and the first fin (122), wherein the first channel (121) extends from a proximity of the impeller (104) to the first outlet (152).

2. The flow shaper (110) of claim 1, further comprising a second fin (124) for the first outlet (152) defining a second channel (123) between the first fin (122) of the first outlet (152) and the second fin (124) of the first outlet (152), wherein the second channel (123) extends from a proximity of the impeller (104) to the first outlet (152).

3. The flow shaper (110) of any of the preceding claims, wherein the first fin (122) extends beyond the first outlet (152) of the centrifugal fan (100).

4. The flow shaper (110) of any of the preceding claims, wherein the first channel (122) comprises a width, wherein the width is at least one of:
at least two millimeters;
at most six millimeters; or
greater than a width between adjacent fins of a fin stack of a heat exchanger abutting the first outlet (152) of the centrifugal fan (100).

5. The flow shaper (110) of any of the preceding claims, further comprising a first fin (122) for the second outlet (154) defining a first channel (125) of the second outlet (154) between the partition structure and the first fin (126) for the second outlet (154), wherein the first channel (125) of the second outlet (154) extends to the second outlet (154).

6. The flow shaper (110) of claim 5, wherein the first channel (125) of the second outlet (154) extends from a proximity of the impeller (104).

7. The flow shaper (110) of any of the preceding claims, wherein the first fin (122) for the first outlet (152) comprises at least one of aluminum or copper.

8. The flow shaper (110) of any of the preceding claims, wherein the first channel (121) of the first outlet (152) extends at least partially along a tangent of the impeller (104).

9. The flow shaper (110) of any of the preceding claims, wherein the first channel (121) of the first outlet (152) extends at least partially along a path originating from a permitter of the impeller (104).

10. The flow shaper (110) of claim 9, wherein the path is a tangential path.

11. A fan chassis (108) for a centrifugal fan (100) comprising the flow shaper (110) of any of the preceding claims.

12. The fan chassis (108) of claims 11, wherein the first fin (122) for the first outlet is (152) integrally formed on a top or base of the fan chassis (108).

13. A heat exchanger (230) affixable to a centrifugal fan (201), the heat exchanger (230) comprising:
a plurality of heat-transfer fins (232) arranged in a fin stack (234), wherein the fin stack (234) has an inlet,
a plurality of channels (221, 223) defined by a plurality of flow-shaping fins (222, 224, 228) extending beyond the inlet of the fin stack (234), wherein a width of the channels is greater than a width between adjacent heat-transfer fins (232) of the fin stack (234).

14. The heat exchanger (230) of claim 13, wherein the flow-shaping fins (222, 224, 228) are integrally formed into the heat-transfer fins (232) of the fin stack (234).

15. A system (200) comprising a centrifugal fan (201) and a heat exchanger (230),
wherein the centrifugal fan (201) comprises an impeller (204) and a first outlet (252) in a first direction and a second outlet (254) in a second direction,
wherein the heat exchanger (230) abuts the first outlet of the centrifugal fan (201), wherein the system (200) comprises:
a partition structure (220) arranged at an inflection area (251) between the first outlet (252) and the second outlet (254), and
a first fin (222) for the first outlet (254) defining a first channel (221) between the partition structure (220) and the first fin (222), wherein the first channel (221) extends from a proximity of the impeller (204) to the first outlet (252).
